(19) Europäisches Patentamt
European Patent Office
Office européen des brevets

(11) **EP 4 206 703 A1**

(12) **EUROPEAN PATENT APPLICATION**

(43) Date of publication:
**05.07.2023 Bulletin 2023/27**

(21) Application number: **22214170.7**

(22) Date of filing: **16.12.2022**

(51) International Patent Classification (IPC):
**G01R 31/28** (2006.01) **G01R 35/00** (2006.01)

(52) Cooperative Patent Classification (CPC):
**G01R 31/2846; G01R 35/005;** G01R 31/62

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.12.2021 PL 43988121**

(71) Applicant: **Skarb Panstwa - Glowny Urzad Miar 00-139 Warszawa (PL)**

(72) Inventors:
• **Tomaszewski, Andrzej**
  **00-453 Warszawa (PL)**
• **Sadkowski, Grzegorz**
  **05-092 omianki (PL)**

(74) Representative: **JWP Patent & Trademark Attorneys**
  **Sienna Center, ul Zelazna 28/30**
  **00-833 Warszawa (PL)**

(54) **SYSTEM AND METHOD FOR SIMULATING TRANSFORMER ERRORS IN CALIBRATING BRIDGES FOR MEASURING TRANSFORMER ERRORS**

(57) The subject-matter of the invention is a system and method for simulating transformer errors in calibrating bridges for measuring transformer errors. The system for simulating transformer errors in calibrating bridges for measuring transformer errors, comprising a signal source with a first output and a second output, and a calibrated bridge with a first input and a second input according to the invention, wherein the first output (N) of the source (Ż) is connected to the first input (N) of the calibrated bridge (MW) through an attachment node (Z) and the second output (B) of the source (Ż) is connected to the second input (X) of the calibrated bridge (MW) through a summation node (S). The first output (N) of the source (Ż) is also connected to the summation node (S) through the attachment node (Z). The method for simu-

lating transformer errors in calibrating bridges for measuring transformer errors according to the invention, wherein a first signal is generated at the first output (N), the signal simulating the secondary signal of the standard transformer, and a second signal is generated at the second output (B), the signal simulating the error signal of the tested transformer. The first signal from the first output (N) and the second signal from the second output (B) are summed to create a summation signal fed to the input (X) of the calibrated bridge (MW). The second signal from the output (B) is phase-shifted with respect to the first signal from the output (N) by a phase-shift angle (β). The value of the error signal from the second output (B) and the phase-shift angle (β) are calculated from the formula.

Fig. 2

EP 4 206 703 A1

**Description**

The subject-matter of the invention is a system and method for simulating transformer errors in calibrating bridges for measuring transformer errors.

A method of calibrating a voltage transformer is known from document CN110133565A, wherein, according to the method, the primary wiring end of a three-phase voltage regulator is connected separately to fuse I, fuse II and fuse III; the other ends of fuse I, fuse II and fuse III are connected to the three-phase AC contactor separately and the other end of the three-phase AC contactor is connected to the 380V AC power supply; the secondary wiring end of a three-phase voltage regulator is connected to the primary wiring ends A, B and C of the voltage transformer separately; voltmeter I is connected between wire end A and wire end B, and voltmeter II is connected between wire end B and wire end C; voltmeter III, voltmeter IV and voltmeter V are connected between wires ends a, b and c, respectively, of the first secondary winding of the voltage transformer, and the zero potential; and voltmeter VI is connected between ends d and the ends of the wires of the second secondary winding of the voltage transformer and the zero potential and then the verification is carried out.

On the other hand, from another document WO2014162020A1, a solution is known for a modular measuring bridge for determining the measurement error in measuring transformers connected to the phase of a high-voltage line, in which said bridge comprises: a first element for obtaining a measurement, at a predetermined time, of a first reference voltage value Vref of a measuring transformer, connected to the same phase; a second element for obtaining a measurement, at the same time as above, of a second voltage value Vmed of the measuring transformer; and a comparator. The first and second elements also comprise transmission means for transmitting the first and second voltage values Vref and Vmed to the comparator, and the comparator comprises reception means for receiving them. Upon receiving the first and second voltage values Vref and Vmed, the comparator is configured to calculate the measurement error; in the measuring transformer.

In addition, state of the art document US2014247056 A1 discloses a solution being a modular measuring bridge for determining the measurement error in transformers. A serial summation and calibration device based on a semi-isolating voltage transformer comprises a symmetrical test high-voltage power supply, a three-port serial voltage transformer, a semi-isolating voltage transformer and an apparatus for measuring errors. This solution is characterized in that: a complete set of devices can be manufactured to measure the traceability of the supply frequency voltage ratio; line calibration according to the serial addition based on the semi-isolating voltage transformer; measurement of the relative error between the three-port serial voltage transformer and the semi-isolating voltage transformer; and mathematical processing of the measurement result to obtain a voltage factor curve of the error of the semi-isolating voltage transformer. The method is easy to operate, is not limited by the voltage level and can establish, from low voltage 10V to high voltage 1000V.

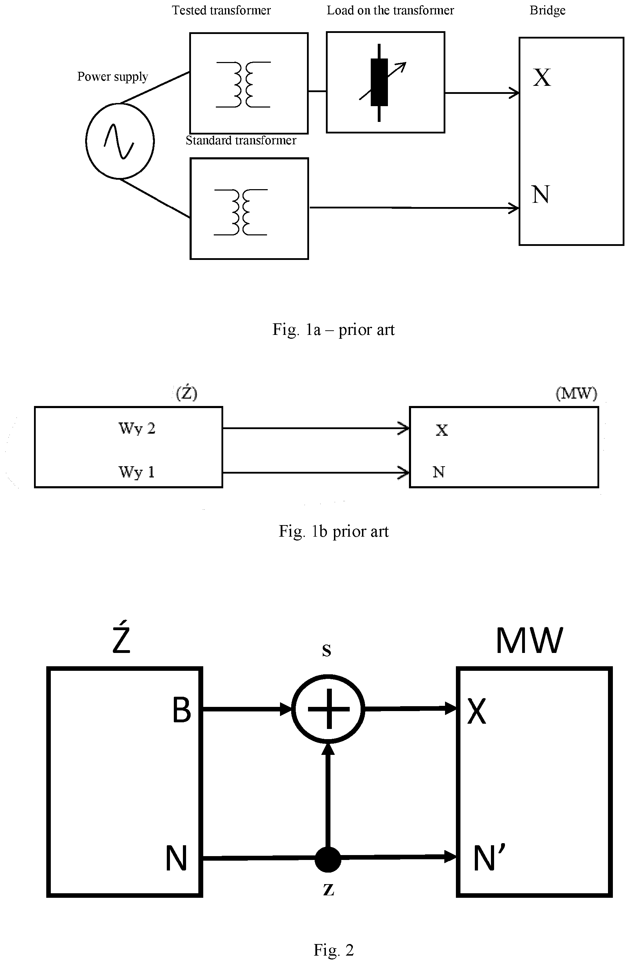

In turn, the typical system for checking transformer errors, shown schematically in Fig. 1a, consists of a standard transformer, a load of the tested transformer and a bridge for determining the errors of the tested transformer.

Bridges for measuring transformer errors are equipped with two pairs of input terminals. The pair designated as X is used to connect the tested transformer, and the pair designated as N is used to connect the standard transformer. The measurement result which is read on the bridge consists of a pair of errors: the ratio error and the phase angle error. A distinction is made between voltage ratio errors and current ratio errors.

Ratio error $\Delta$, as measured by the bridge, is the ratio of the signal difference at input terminals X and N to the signal at terminals N. The ratio error is expressed as a percentage and described by the following formula:

$$\Delta = \frac{X - N}{N} \cdot 100\%$$ ,

where:

$\Delta$ - ratio error,
$X$ - signal at terminals X of the bridge,
$N$ - signal at terminals N of the bridge.

Phase angle error $\delta$ is a phase-shift between the signals at terminals X and N and is most often expressed in arc minutes (diagram below). It shows its vector interpretation.

Vector diagram – illustration of the phase angle error

Maximum errors of measuring transformers (classes 0.1, 0.2, 0.5, 1) are within ± 3% and ± 180 min [PN-EN 61869-2:2013-06 - Transformers -- Part 2: Specific requirements for current transformers and PN-EN 61869-3:2011 - Transformers -- Part 3: Specific requirements for inductive voltage transformers], therefore the bridge should be calibrated in a similar range.

When calibrating bridges, the errors of the tested transformer are simulated using synchronized voltage sources or current sources, in the case of voltage bridges or current bridges, respectively. The source should provide two synchronized outputs. Such sources may be three-phase current and voltage setters for setting measurement points when calibrating electricity meters or three-phase power and energy calibrators.

Based on the definition of the ratio error and the phase angle error, it may seem that the best way to simulate the errors of the tested transformer is to connect one source output to one pair of terminals and connect the second source output to the other pair of terminals of the calibrated bridge and provide appropriate signal values and phase-shift between them (Fig. 1b.). This approach is intuitive.

However, in practice, in this measuring system, there are problems with stability and resolution of the arranged measuring points. This is due to the small value of the phase-shift angle $\delta$ (of the order of arc minutes) in relation to the accuracy offered by three-phase calibrators for phase-to-phase signals. In the case of the ratio error, it is similar, both X and N signals are of similar value, so it is difficult to obtain a stable value of the ratio error due to the small ratio of their difference to the amplitude of N signal.

The invention provides a solution which avoids the disadvantages of the intuitive system described above, i.e. the stability and resolution problems of the arranged measuring points.

A system for simulating transformer errors in calibrating bridges for measuring transformer errors, comprising a signal source with a first output and a second output, and a calibrated bridge with a first input and a second input according to the invention, wherein the first output of the source is connected to the first input of the calibrated bridge through an attachment node and the second output of the source is connected to the second input of the calibrated bridge through a summation node. The first output of the source is also connected to the summation node through the attachment node.

A method for simulating transformer errors in calibrating bridges for measuring transformer errors according to the invention, wherein the source generates a first signal at the first output, the signal simulating the secondary signal of the standard transformer, and the source generates a second signal at the second output, the signal simulating the error signal of the tested transformer. The summation node sums the first signal from the first output and the second signal from the second output, creating a summation signal fed to the input of the calibrated bridge.

Preferably, the second signal from the output is phase-shifted with respect to the first signal from the output by a phase-shift angle.

Preferably, the value of the error signal from the second output and the phase-shift angle are calculated from the formula:

$$B = \sqrt{X^2 - 2XN\cos\delta + N^2}$$

$$\beta = \arccos\frac{X\cos\delta - N}{B}$$

where

N is the value of the simulated secondary signal of the standard transformer.

X is the value of the simulated secondary signal of the tested transformer.

$\delta$ is the value of the simulated phase angle error of the tested transformer.

The subject-matter of the invention in the embodiments is illustrated in the drawings in which:

Fig. 2 presents a block diagram of the system for simulating transformer errors in calibrating bridges,

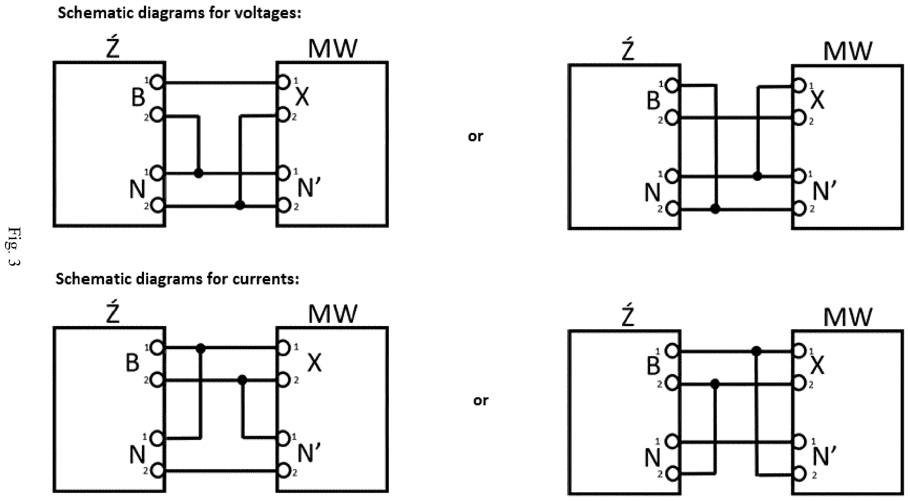

Fig. 3 shows schematic diagrams for currents and voltages of the systems for simulating transformer errors in calibrating bridges.

The present invention concerning the system and method for simulating transformer errors in calibrating bridges for measuring transformer errors will be further explained in the embodiments of the solution for each category of the invention.

The system for simulating transformer errors in calibrating bridges for measuring transformer errors, comprising a signal source with a first output (N) and a second output (B), and a calibrated bridge (MW) with a first input (N') and a second input (X) according to the invention, wherein the first output (N) of the source (Z) is connected to the first input (N') of the calibrated bridge (MW) through the attachment node (Z) and the second output (B) of the source (Z) is connected to the second input (X) of the calibrated bridge (MW) through the summation node (S). The first output (N) of the source (Z) is also connected to the summation node (S) through the attachment node (Z).

In the first variant for voltage bridges, the first outputs (N1, N2) of the source (Z) are connected to the first inputs (N'1, N'2) of the calibrated bridge (MW), and the second output (B1) is connected to the second input (X1) of the calibrated bridge (MW), also the first output (N1) is connected to the second output (B2), and the first output (N2) is connected to the second input (X2).

In the second variant for the voltage bridge, the first outputs (N1, N2) of the source (Z) are connected to the first inputs (N'1, N'2) of the calibrated bridge (MW), and the second output (B2) is connected to the second input (X2) of the calibrated bridge (MW), also the first output (N2) is connected to the second output (B1), and the first output (N1) is connected to the second input (X1).

In the first variant for the current bridge, the second outputs (B1, B2) of the source (Z) are connected to the second inputs (X1, X2) of the calibrated bridge (MW), and the first output (N2) is connected to the first input (N'2) of the calibrated bridge (MW), also the second output (B1) is connected to the first output (N1) and the second output (B2) is connected to the first input (N'1).

In the second variant for the current bridge, the second outputs (B1, B2) of the source (Z) are connected to the second inputs (X1, X2) of the calibrated bridge (MW), and the first output (N1) is connected to the first input (N'1) of the calibrated bridge (MW), also the second output (B2) is connected to the first output (N2), and the second output (B1) is connected to the first input (N'2).

The method for simulating transformer errors in calibrating bridges for measuring transformer errors according to the invention, wherein the source (Z) generates a first signal at the first output (N), the signal simulating the secondary signal of the standard transformer, and the source (Z) generates a second signal at the second output (B), the signal simulating the error signal of the tested transformer. The summation node (S) sums the first signal from the first output (N) and the second signal from the second output (B), creating a summation signal fed to the input (X) of the calibrated bridge (MW). The second signal from the output (B) is phase-shifted with respect to the first signal from the output (N) by a phase-shift angle (β).

This is illustrated schematically in the diagram below.

Vector diagram – trigonometric approach

Using trigonometric transformations, the values of error signal *B* and angle *β* can be calculated from the following formulas.

$$B = \sqrt{X^2 - 2XN \cos \delta + N^2} \qquad (2)$$

$$\beta = \arccos\frac{X\cos\delta - N}{B} \qquad (3)$$

where

N is the value of the simulated secondary signal of the standard transformer.
X is the value of the simulated secondary signal of the tested transformer.
$\delta$ is the value of the simulated phase angle error of the tested transformer.

The above approach may be termed trigonometric. It results in better resolution and stability of simulated errors of the tested transformer. In addition, when the source of the signals is also a standard during the calibration of the bridge, i.e. the values of simulated transformer errors resulting from the source settings are standard values, with the trigonometric approach, significantly lower uncertainties of these values are obtained than with an intuitive approach. A comparison of the exemplary type B uncertainty values, when the three-phase calibrator Model 8100-3P was used as the source, is presented in Table 1.

Table 1. Comparison of the uncertainties estimated for simulating transformer errors with the Model 8100-3P calibrator using the intuitive approach and the trigonometric approach, i.e. in accordance with the invention.

| Values of simulated transformer errors | | Type B uncertainty of simulated transformer errors | | | |
|---|---|---|---|---|---|
| | | intuitive approach | | trigonometric approach | |
| $\Delta$, % | $\delta$, min | u($\Delta$), % | u($\delta$), min | u($\Delta$), % | u($\delta$), min |
| 0.1 | 5 | 0.012 | 0.35 | 0.000022 | 0.00091 |
| 0.2 | 10 | 0.012 | 0.35 | 0.000039 | 0.0015 |
| 0.5 | 20 | 0.012 | 0.35 | 0.000083 | 0.0029 |
| 1 | 40 | 0.012 | 0.35 | 0.00017 | 0.0058 |
| 3 | 120 | 0.013 | 0.35 | 0.00056 | 0.020 |

The results summarized in Table 1 show that the solution according to the invention makes it possible to simulate transformer errors more accurately by several orders of magnitude, both for the ratio error and the phase angle error.

**List of References**

**MW** - calibrated bridge
**Ż** - source of signals
**B** - second output of the source of signals
**N** - first output of the source of signals
**N'** - first input of the calibrated bridge
**X** - second input of the calibrated bridge
**S** - summation node
**Z** - attachment node
β - the value of the phase-shift angle of B signal in relation to N signal
**N1, N2** - first outputs of the source of signals
**B1, B2** - second outputs of the source of signals
**X1, X2** - second inputs of the calibrated bridge
**N' 1, N'2** - first inputs of the calibrated bridge

**Claims**

**1.** A system for simulating transformer errors in calibrating bridges for measuring transformer errors, comprising a

signal source (Ż) with a first output (N) and a second output (B), and a calibrated bridge (MW) with a first input (N) and a second input (X), **characterized in that**

the first output (N) of the source (Ż) is connected to the first input (N) of the calibrated bridge (MW) through an attachment node (Z) and the second output (B) of the source (Ż) is connected to the second input (X) of the calibrated bridge (MW) through a summation node (S), wherein
the first output (N) of the source (Ż) is also connected to the summation node (S) through the attachment node (Z).

2. A method for simulating transformer errors in calibrating bridges for measuring transformer errors **characterized in that**

the source (Ż) generates a first signal at the first output (*N*), the signal stimulating a secondary signal of the standard transformer and
the source (Ż) generates a second signal at the second output (*B*), the signal stimulating an error signal of the tested transformer and then
the summation node (S) sums the first signal from the first output (*N*) and the second signal from the second output (*B*), creating a summation signal fed to the input (X) of the calibrated bridge (MW).

3. The method of claim 2 **characterized in that** the second signal from the second output (*B*) is phase-shifted with respect to the first signal from the first output (*B*) by a phase-shift angle ($\beta$).

4. The method of claim 2 or 3, **characterized in that** the value of the error signal from the second output (B) and the phase-shift angle ($\beta$) are calculated from the formula:

$$B = \sqrt{X^2 - 2XN\cos\delta + N^2}$$

$$\beta = \arccos\frac{X\cos\delta - N}{B}$$

where

A is the value of the simulated secondary signal of the standard transformer
X is the value of the simulated secondary signal of the tested transformer
$\delta$ is the value of the simulated phase angle error of the tested transformer.

Tested transformer     Load on the transformer     Bridge

Power supply

Standard transformer

Fig. 1a – prior art

(Ź)                          (MW)

Wy 2              X

Wy 1              N

Fig. 1b prior art

Ź                   s              MW

B           ⊕          X

N              N'

z

Fig. 2

Schematic diagrams for voltages:

Schematic diagrams for currents:

Fig. 3

| Europäisches Patentamt European Patent Office Office européen des brevets | **EUROPEAN SEARCH REPORT** | **Application Number** EP 22 21 4170 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SIEGENTHALER STEFAN ET AL: "A Computer-Controlled Calibrator for Instrument Transformer Test Sets", IEEE TRANSACTIONS ON INSTRUMENTATION AND MEASUREMENT, IEEE, USA, vol. 66, no. 6, 1 June 2017 (2017-06-01), pages 1184-1190, XP011648790, ISSN: 0018-9456, DOI: 10.1109/TIM.2017.2659858 [retrieved on 2017-05-10] * Sections II, III; figures 1, 2 * | 1-4 | INV. G01R31/28 G01R35/00 |
| A | MESTER CHRISTIAN ET AL: "A computer-controlled calibrator for instrument transformer test sets", 2016 CONFERENCE ON PRECISION ELECTROMAGNETIC MEASUREMENTS (CPEM 2016), IEEE, 10 July 2016 (2016-07-10), pages 1-2, XP032943437, DOI: 10.1109/CPEM.2016.7540543 [retrieved on 2016-08-10] * figures 2,3 * | 1-4 | |
| A | BETTS P J ET AL: "SELF-CALIBRATABLE VOLTAGE TRANSFORMER TESTING SET", IEEE TRANSACTIONS ON INSTRUMENTATION AND MEASUREMENT, IEEE, USA, vol. 48, no. 5, 1 October 1999 (1999-10-01), pages 906-908, XP000947169, ISSN: 0018-9456, DOI: 10.1109/19.799645 * section III * | 1-4 | |

**TECHNICAL FIELDS SEARCHED (IPC)**

G01R

-/--

The present search report has been drawn up for all claims

| Place of search | Date of completion of the search | Examiner |
|---|---|---|
| Munich | 23 May 2023 | Meliani, Chafik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 22 21 4170

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WO 2014/162020 A1 (ARTECHE CT DE TECNOLOGÍA A I E [ES]) 9 October 2014 (2014-10-09) * claim 1 * ----- | 1-4 | |
| A,D | US 2014/247056 A1 (ZHOU FENG [CN] ET AL) 4 September 2014 (2014-09-04) * claim 1 * ----- | 1-4 | |

| | | | TECHNICAL FIELDS SEARCHED (IPC) |

The present search report has been drawn up for all claims

| Place of search | Date of completion of the search | Examiner |
|---|---|---|
| Munich | 23 May 2023 | Meliani, Chafik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 4170

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2023

| Patent document cited in search report | | Publication date | Patent family member(s) | | Publication date |
|---|---|---|---|---|---|
| WO 2014162020 | A1 | 09-10-2014 | AR | 095731 A1 | 04-11-2015 |
| | | | WO | 2014162020 A1 | 09-10-2014 |
| US 2014247056 | A1 | 04-09-2014 | CN | 102353919 A | 15-02-2012 |
| | | | US | 2014247056 A1 | 04-09-2014 |
| | | | WO | 2013004042 A1 | 10-01-2013 |

EPO FORM P0459

For more details about this annex : see Official Journal of the European Patent Office, No. 12/82

**EP 4 206 703 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110133565 A
- WO 2014162020 A1
- US 2014247056 A1